Europäisches Patentamt

European Patent Office

Office européen des brevets

(11) Veröffentlichungsnummer: **0 311 808**
**A2**

(12) **EUROPÄISCHE PATENTANMELDUNG**

(21) Anmeldenummer: **88115064.3**

(22) Anmeldetag: **15.09.88**

(51) Int. Cl.⁴: **H04R 3/00 , G10L 3/00**

(30) Priorität: **12.10.87 DE 3734446**

(43) Veröffentlichungstag der Anmeldung:
**19.04.89 Patentblatt 89/16**

(84) Benannte Vertragsstaaten:
**AT BE CH ES FR GB IT LI LU NL**

(71) Anmelder: **TELENORMA Telefonbau und Normalzeit GmbH**
**Mainzer Landstrasse 128-146**
**D-6000 Frankfurt am Main(DE)**

(72) Erfinder: **Gierlich, Hans Wilhelm, Dipl.-Ing.**
**Roermonder Strasse 112**
**D-5100 Aachen(DE)**

(54) **Verfahren und Schaltungsanordnung zur Störgeräuschkompensation für ein Mikrofon.**

(57) Es ist ein Verfahren und eine Schaltungsanordnung zur Behandlung der Mikrofonsignale anzugeben, welches zur besseren Verständlichkeit der Sprachsignale die störenden Raumgeräusche unterdrückt.

Nach einer Bandpaßfilterung für die Sprachgrundfrequenz des Mikrofonsignals wird die Einhüllende von Sprache desselben detektiert und das Detektionssignal zur Steuerung eines Regelverstärkers derart verwendet, daß dieser bei fehlendem Detektionssignal das Mikrofonsignal dämpft und bei vorhandenem Dektektionssignal verstärkt.

Fig. 1

## Verfahren und Schaltungsanordnung zur Störgeräuschkompensation für ein Mikrofon

Die Erfindung betrifft ein Verfahren und eine Schaltungsanordnung zur Störgeräuschkompensation für ein Mikrofon, wobei die von dem Mikrofon erzeugten Signale einem Verstärker zugeführt werden.

Bei der Aufnahme von akustischen Nutzsignalen, beispielsweise von Sprachsignalen in Räumen mit Störgeräuschen wird die Sprachverständlichkeit durch die Störgeräusche beeinträchtigt. Zur Verringerung des Einflusses der Störgeräusche gibt es verschiedene Möglichkeiten, beispielsweise die Verwendung eines Mikrofons mit Richtcharakteristik. Eine andere Möglichkeit besteht beispielsweise darin, zwei über einen Mikrofonverstärker gegeneinander geschaltete und räumlich eng benachbarte Mikrofone zu verwenden. So wird in der DE-PS 29 31 604 eine störgeräuschkompensierte Mikrofonschaltung beschrieben, bei welcher vor Aufnahme eines Sprechbetriebes eine zeitindividuelle Einstellung der optimalen Geräuschkompensation dadurch herbeigeführt werden kann, daß der Geräuschpegel mittels eines geeigneten Indikators sichtbar oder hörbar gemacht und außerdem eine geeignete Regeleinrichtung vorgesehen wird, die den Benutzer befähigt, die optimale Anpassung der Mikrofonschaltung an das Störgeräusch der Umgebung jederzeit vornehmen zu können.

Die Aufgabe der Erfindung besteht nun darin, ein Verfahren und eine Schaltungsanordnung zur Störgeräuschkompensation für ein Mikrofon anzugeben, bei welcher sowohl ein zweites Mikrofon als auch eine manuelle Einstellung des Mikrofonverstärkers vermieden wird.

Diese Aufgabe wird dadurch gelöst, daß nach einer Bandpaßfilterung des Mikrofonsignals die Einhüllende von Sprache desselben detektiert wird und daß das Detektionssignal zur Steuerung eines Regelverstärkers derart dient, daß dieser bei fehlendem Detektionssignal das Mikrofonsignal dämpft und bei vorhandenem Detektionssignal verstärkt.

Durch die Erfindung läßt sich in störschallerfüllter Umgebung eindeutig das Sprachsignal vom Störgeräusch unterscheiden.

Eine Weiterbildung der Erfindung besteht in einer Schaltungsanordnung zur Durchführung des Verfahrens, wobei diese aus einer Serienschaltung eines Bandpaßfilters für den Bereich (der Sprachgrundfrequenz von z. B.) von 90 bis 300 Hz, eines Gleichrichters, eines Demodulators für die Einhüllende von Sprache, einem Zeitglied mit einer Ansprechverzögerung von 60-120 ms und einem Halteglied mit einer Verzögerung von 0,4-1,4 S besteht, wobei der Ausgang des Halteglieds mit dem das Mikrofonsignal steuernden Regelverstärker verbunden ist.

Das Zeitglied verhindert dabei Fehlentscheidungen, die aufgrund von kurzen Störimpulsen verursacht werden könnten. Das Halteglied dient zur Überbrückung von kurzen Sprachpausen und stimmlosen Lauten.

Eine Weiterbildung der Erfindung für einen Fernsprechapparat mit einer Hörkapsel besteht darin, daß das Ausgangssignal des Halteglieds einem weiteren Regelverstärker zugeführt wird, welcher das Signal für die Hörkapsel steuert, wobei bei fehlendem Detektionssignal das Signal für die Hörkapsel verstärkt wird.

Durch diese Maßnahme wird die Sprachverständlichkeit bei einem Fernsprechapparat in störgeräuscherfüllter Umgebung weiter gesteigert.

Weitere Vorteile ergeben sich aus den Unteransprüchen.

Die Erfindung wird anhand eines Ausführungsbeispiels näher erläutert, welches in der Zeichnung dargestellt ist.

Es zeigt:

Fig. 1 das Blockschaltbild zur Störgeräuschkompensation für Mikrofonsignale und

Fig. 2 eine Schaltungsanordnung zur Störgeräuschkompensation für einen Handapparat eines Fernsprechapparates mit Mikrofon und Hörkapsel.

Das Mikrofonsignal des Mikrofons M wird zunächst einem Bandpaßfilter BP mit einem Durchlaßbereich (im Bereich der Sprachgrundfrequenz) von 90 bis 300 Hz zugeführt. Das Ausgangssignal das Bandpaßfilters BP wird nach einer Gleichrichtung durch den Gleichrichter GL 1 Demodulator DM demoduliert, und zwar erfolgt dort die Detektion der Einhüllenden von Sprache. Enthält das Mikrofonsignal kein Sprachsignal, so ist auch am Ausgang des Demodulators DM kein Ausgangssignal vorhanden. Enthält das Mikrofonsignal jedoch ein Sprachsignal dann wird das am Ausgang des Demodulators DM entstehende Signal einer Verzögerungsstufe VZ zugeführt, welche das Eingangssignal um 60-120 ms verzögert, um auf diese Weise Fehlentscheidungen aufgrund von Störungen durch kurze Impulse zu verhindern.

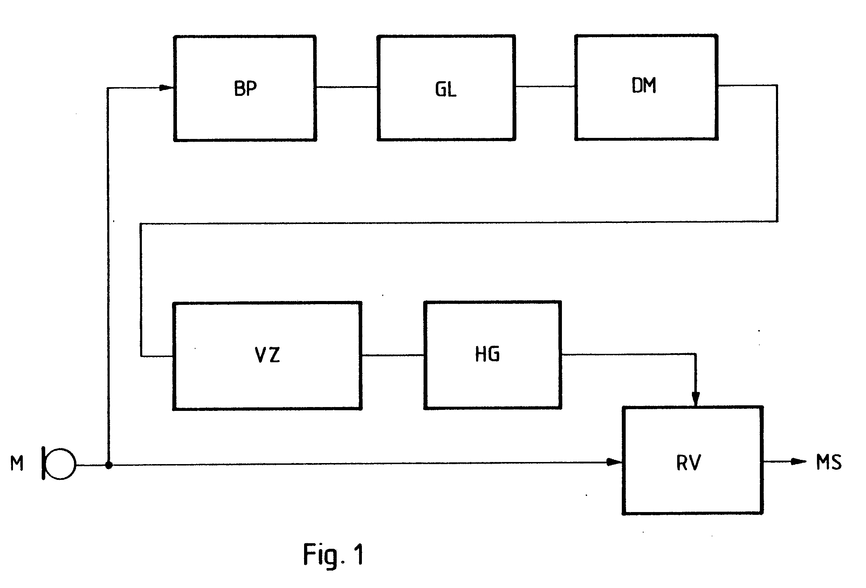

Liegt das Ausgangssignal des Demodulators DM länger als 120 ms an der Verzögerungsstufe VZ an, dann entsteht an derselben ein Ausgangssignal, welches einem Halteglied HG zugeführt wird. Dieses Halteglied gibt das Eingangssignal sofort an seinen Ausgang weiter, wobei das Eingangssignal noch um 0,4-1,4 Sek nach dem Abschalten desselben am Ausgang des Halteglieds HG vorhanden ist. Das Halteglied HG dient zur Überbrückung von kurzen Sprachpausen und stimmlosen Lauten. Das Ausgangssignal des Haltegliedes HG dient schließlich zur Steuerung des Regelverstärkers RV, dem ebenfalls das Mikrofonsignal zugeführt wird. (s. Fig. 1) Eine Schaltungsanordnung auf der Grundlage des in Fig. 1 gezeigten Blockschaltbildes könnte beispielsweise als integrierte Schaltung verwirklicht und in einer Mikrofonkapsel integriert werden, wobei die Stromversorgung derselben ebenfalls über die beiden Anschlüsse der Mikrofonkapsel erfolgt.

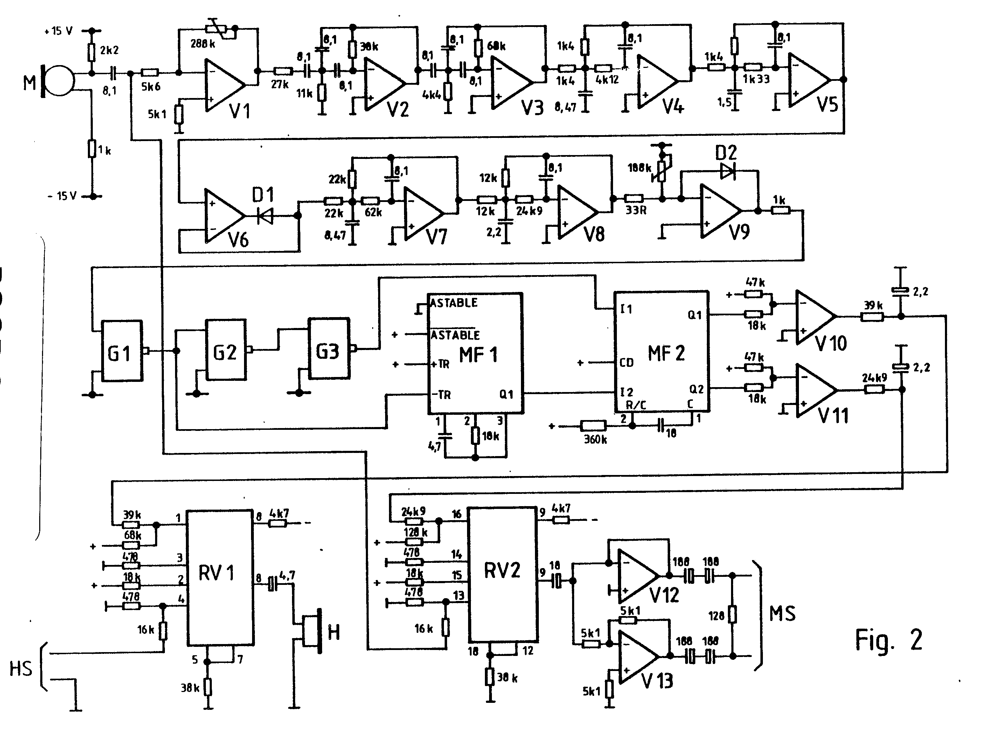

Die in Fig. 2 gezeigte Schaltungsanordnung dient sowohl zur Störgeräuschkompensation von Mikrofonsignalen als auch zur Regelung der elektrischen Signale für die Hörkapsel, wobei Mikrofon und Hörkapsel beispielsweise in dem Handapparat eines Fernsprechapparates eingesetzt sind.

Die Signale des Mikrofons M werden zunächst einem Operationsverstärker zur Pegeleinstellung für das aus den Operationsverstärkern V2 bis V5 gebildete Bandpaßfilter zugeführt. Der Operationsverstärker V6 bildet zusammen mit der Diode D1 die Gleichrichterstufe, in welcher das Ausgangssignal des Bandpaßfilters gleichgerichtet wird. In der aus den Operationsverstärkern V7 bis V9 gebildeten Demodulatorstufe erfolgt die Detektion der Einhüllenden von Sprache, wobei das Ausgangssignal dem als Umkehrstufe wirkenden Gatter G1 zugeführt wird. Der Ausgang des Gatters G1 ist mit dem Eingang des als monostabile Kippstufe ausgebildeten Zeitglied MF1 verbunden, dessen Ansprechverzögerung 120 ms beträgt. Der Ausgang der monostabilen Kippstufe MF1 ist dem Eingang der monostabilen Kippstufe MF2 verbunden, welche eine Abfallverzögerung von 1,4 s aufweist. Die Freigabe der monostabilen Kippstufe MF2 erfolgt durch das um die Gatterlaufzeit der NAND-Gatter G2 und G3 verzögerte Ausgangssignal des NAND-Gatters G1.

Der Ausgang Q2 der monostabilen Kippstufe MF2 ist über den Operationsverstärker V11 mit dem Regelverstärker RV2 verbunden, an dessen Eingang 13 das Mikrofonsignal anliegt. Der Regelverstärker RV2 arbeitet derart, daß die Empfindlichkeit des Mikrofons um 5-20 dB reduziert wird, so lange kein Sprachsignal erkannt wird. Ist dagegen ein Sprachsignal vorhanden, so wird über den Regelverstärker RV2 das Mikrofonsignal auf 0 dB geregelt. Das in der beschriebenen Weise behandelte Mikrofonsignal steht dann am Ausgang MS zur Verfügung.

Gleichzeitig erfolgt über den Ausgang Q1 der monostabilen Kippstufe MF2 über den Operationsverstärker V10 die Steuerung des Regelverstärkers RV1, an dessen Eingang das Signal für die Hörkapsel HS anliegt und an dessen Ausgang die Hörkapsel H angeschlossen ist. Die Steuerung des Regelverstärkers RV1 erfolgt dabei derart, daß bei Vorhandensein eines Sprachsignals das Signal für die Hörkapsel H auf 0 dB geregelt wird, während bei fehlendem Sprachsignal die Verstärkung des Signals für die Hörkapsel H um 5-15 dB erfolgt.

Eine derartige Schaltungsanordnung kann beispielsweise für die in einem Handapparat untergebrachten elektroakustischen Wandler, nämlich das Mikrofon und die Hörkapsel verwendet werden, wobei die Schaltungsanordnung auch im Handapparat selbst untergebracht werden kann.

Verwendete Bauteile:
V1 bis V11 = TL 064
V12, V13 = TL 072
D1, D2 = 1N 4148
G1 bis G3 = 4093
MF1 = 4047
MF2 = 4528
RV1, RV2 = NE 5517
sämtliche Kondensatorwerte in µF
Toleranzen sämtlicher Widerstände: 1 %

Die angegebenen Zeit- und Dämpfungswerte sind nur beispielhaft zu verstehen.

## Ansprüche

1. Verfahren zur Störgeräuschkompensation für ein Mikrofon, wobei die von dem Mikrofon erzeugten Signale einem Verstärker zugeführt werden, dadurch gekennzeichnet, daß nach einer Bandpaßfilterung für die Sprachgrundfrequenz des Mikrofonsignals die Einhüllende von Sprache desselben detektiert wird und daß das Detektionssignal zur Steuerung eines Regelverstärkers (RV) derart dient, daß dieser bei fehlendem Detektionssignal das Mikrofonsignal dämpft und bei vorhandenem Detektionssignal verstärkt.

2. Verfahren nach Anspruch 1, dadurch gekennzeichnet, daß der Regelverstärker (RV) bei fehlendem Detektionssignal das Mikrofonsignal um 5-20 dB dämpft und bei vorhandenem Detektionssignal das Mikrofonsignal auf 0 dB regelt.

3. Verfahren nach Anspruch 1 oder 2, dadurch gekennzeichnet, daß das Detektionssignal einem Zeitglied (VZ) zugeführt wird, welches eine bestimmte Ansprechverzögerung aufweist und daß das Ausgangssignal des Zeitgliedes (VZ) zur Steuerung des Regelverstärkers (RV) dient.

4. Verfahren nach einem der Ansprüche 1 bis 3, dadurch gekennzeichnet, daß zwischen das Zeitglied (VZ) und dem Regelverstärker (RV) ein Halteglied (HG) mit einer bestimmten Verzögerung geschaltet ist.

5. Schaltungsanordnung zur Durchführung des Verfahrens nach einem der Ansprüche 1 bis 4, bestehend aus einer Serienschaltung eines Bandpaßfilters (BP) für den Bereich (der Sprachgrundfrequenz von z. B.) von 90 bis 300 Hz, einem Gleichrichters (GL), einem Demodulators (DM) für die Einhüllende von Sprache, einem Zeitglied (VZ) mit einer Ansprechverzögerung von 60- 120 ms und einem Halteglied (HG) mit einer Verzögerung von 0,4-1,4 S wobei der Ausgang des Haltegliedes (HG) mit dem das Mikrofonsignal steuernde Regelverstärker (RV) verbunden ist.

6. Schaltungsanordnung nach Anspruch 5,
dadurch gekennzeichnet,
daß sämtliche Einrichtungen als integrierte Schaltung in einer Mikrofonkapsel untergebracht sind.

7. Schaltungsanordnung für einen Fernsprechapparat mit einer Hörkapsel nach Anspruch 5,
dadurch gekennzeichnet,
daß das Ausgangssignals des Haltegliedes (HG) einem weiteren Regelverstärker (RV2) zugeführt wird, welcher das Signal für die Hörkapsel steuert, wobei fehlendem Detektionssignal das Signal für die Hörkapsel verstärkt wird.

8. Schaltungsanordnung nach Anspruch 7,
dadurch gekennzeichnet,
daß bei fehlendem Detektionssignal das Signal für die Hörkapsel um 5-15dB verstärkt wird.

9. Schaltungsanordnung nach einem der Ansprüche 7 oder 8,
dadurch gekennzeichnet,
daß die Schaltungsanordnung im Handapparat eines Fernsprechapparates untergebracht ist.

MS

DM

GL

BP

HG

VZ

RV

M

Fig. 1

POOR QUALITY

Fig. 2

EP 0 311 808 A2